# EUROPEAN PATENT APPLICATION

(11) **EP 3 885 807 A1**
(43) Date of publication of application: **29.09.2021**
(21) Application number: 18940845.3
(22) Date of filing: 25.12.2018
(51) Int. Cl.: G02B 6/42, H01S 5/024

(54) **HIGH-SPEED EML COAXIAL TRANSMITTING MODULE AND MANUFACTURING METHOD THEREFOR**

(30) Priority: 23.11.2018 CN 201811407694
(71) Applicant: Wuhan Telecommunication Devices Co., Ltd., Hubei 430074 (CN)
(72) Inventor: RUAN, Yang, Wuhan, Hubei 430074 (CN); LIU, Chenggang, Wuhan, Hubei 430074 (CN); MEI, Xue, Wuhan, Hubei 430074 (CN); WU, Bin, Wuhan, Hubei 43007 (CN)
(74) Representative: Frenkel, Matthias Alexander
(86) International application number: PCT/CN2018/123318
(87) International publication number: WO 2020/103277

(57) **Abstract**

A high-speed EML coaxial transmitting module, comprising a TO header (1), a TEC (2), a ceramic substrate (3), an EML chip (4) and a thermistor (5); wherein a first side of the TEC (2) is arranged on the TO header (1); the ceramic substrate (3) is arranged on a second side of the TEC (2); the EML chip (4) is arranged on the ceramic substrate (3); a lower surface of the thermistor (5) is fixed on the ceramic substrate (3) and close to the EML chip (4); an upper surface of the thermistor (5) is electrically connected to a pad of the ceramic substrate (3); and the pad of the ceramic substrate (3) is electrically connected to a pin of the thermistor (5) on the TO header (1). Under high and low temperature conditions, the high-speed EML coaxial transmitting module can make the temperature of the upper and lower surfaces of the thermistor (5) as consistent as possible, thereby ensuring DWDM wavelength stability at high and low temperature. Further provided is a method for manufacturing the high-speed EML coaxial transmitting module.

## Description

### CROSS-REFERENCE

The present disclosure claims benefit of and priority to Chinese Patent Application No. 201811407694.5, filed on November 23, 2018, entitled "HIGH-SPEED EML COAXIAL TRANSMITTING MODULE AND MANUFACTURING METHOD THEREOF", the disclosure of which is hereby expressly incorporated by reference in its entirety.

### TECHNICAL FIELD OF THE DISCLOSURE

The present disclosure relates to the field of optical communication technology, in particular to a high-speed EML coaxial transmitting module and a manufacturing method thereof.

### BACKGROUND

In the field of optical communication, an Electroabsorption Modulated Laser (EML) is mainly used for long-distance transmission. High-speed EML lasers used for 10G and 25G are usually packaged in the form of BOX packaging, which is relatively high cost and not conducive to mass production. In recent years, for the application of 5G communication network and optical transmission network, there is a strong demand for the development of 10G and 25G low-cost and low-power Dense Wavelength Division Multiplexing (DWDM) operating temperature modules. Therefore, it is necessary to develop an EML transmitting module with refrigeration coaxial packaging that can meet the requirements.

In view of the requirements for low-power DWDM operating temperature module, the current coaxially packaged EML devices have the following two problems:

First, a wavelength of existing coaxially packaged EML device varies within a high and low temperature range of the DWDM operating temperature module, and the variation amount thereof has exceeded a tolerance range of the DWDM wavelength. Because an internal thermistor of the EML device has two electrodes on an upper surface and a lower surface, and the lower surface is bonded on a ceramic substrate and has the temperature close to actual operating temperature of the chip, but the temperature of the upper surface of the thermistor is greatly affected by the surrounding heat conduction factors, resulting in a temperature difference between the upper surface and the lower surface of the thermistor.

Generally, the DWDM operating temperature module sets the thermistor monitoring temperature to be a certain value. When the housing surface temperature of the DWDM operating temperature module is at low temperature, the thermo electric cooler (TEC) will overheat, that is, the actual operating temperature of the chip is higher than the monitoring temperature of the thermistor. When the housing surface temperature of the DWDM operating temperature module is at high temperature, overcooling of the TEC will occur, that is, the actual operating temperature of the chip is lower than the monitoring temperature of the thermistor. As a result, the wavelength of the EML device varies in the high and low temperature range. And the wider the application temperature range of the DWDM operating temperature module is, the greater the relative variation of wavelength will be. For the DWDM operating temperature module (a temperature range of -40 ∼ 85°C), the wavelength of the current coaxial refrigeration EML device at the high and low temperature limit temperature has exceeded the tolerance range of the DWDM wavelength (λ±0.08nm) and cannot meet the DWDM application requirements.

In view of this problem, the DWDM operating temperature module level can use a method of temperature compensation via software, that is, the wavelength at different temperature points can be compensated according to the relationship between the housing surface temperature of DWDM operating temperature module and the thermistor monitoring temperature, based on a look-up table method. However, this method relies on the consistency kept between the packaging of each EML device and the assembly on the module. It is difficult to ensure the accuracy of wavelength control in a wide temperature range in mass production, and cannot meet the wavelength requirements of DWDM.

Second, the power consumption of current coaxially packaged EML is high at high temperature of 85°C, which could hardly meet the low power consumption requirements of DWDM operating temperature modules. The primary reason for the high power consumption is related to the TO-CAN package design.

In view of this, the problem to be solved urgently in this technical field is to overcome the defects of the prior art.

### SUMMARY

The present disclosure provides a high-speed EML coaxial transmitting module and a manufacturing method thereof. The technical problem to be solved by the present disclosure is that the variation amount of the wavelength of the existing coaxially packaged EML device within the high and low temperature range of the DWDM operating temperature module is beyond the DWDM wavelength tolerance range.

In the present disclosure, the following technical solutions are utilized:

In the first aspect, the present disclosure provides a high-speed EML coaxial transmitting module comprising a TO header, a TEC, a ceramic substrate, an EML chip, and a thermistor; a first surface of the TEC being arranged on the TO header, the ceramic substrate being arranged on a second surface of the TEC, the EML chip being arranged on the ceramic substrate, a lower surface of the thermistor being fixed on the ceramic substrate and being close to the EML chip, an upper surface of the thermistor being electrically connected with a pad of the ceramic substrate, and the pad of the ceramic substrate being electrically connected with a thermistor pin on the TO header.

Preferably, the high-speed EML coaxial transmitting module further comprises a heat insulation block, a lower surface of which is fixed on the TO header; the pad of the ceramic substrate being electrically connected to the thermistor pin on the TO header. Specifically, one end of a conductive layer on the upper surface of the heat insulation block is electrically connected to the pad, and the other end of the conductive layer on the upper surface of the heat insulation block is electrically connected to the thermistor pin on the TO header.

Preferably, the upper surface of the thermistor is electrically connected with the pad of the ceramic substrate. Specifically, the upper surface of the thermistor is electrically connected to the pad of the ceramic substrate via at least two gold welding wires.

Preferably, a boss is provided at a concentric position of a radio frequency pin of the TO header, the boss being in a ring structure, the radio frequency pin serving as an inner conductor, the boss serving as an outer conductor, and the radio frequency pin and the boss forming a section of radio frequency coaxial transmitting line, the impedance of which is a predetermined value.

Preferably, a distance between an upper surface of the boss and the upper surface of the TO header is a first distance, and a distance between the upper surface of the TEC and the upper surface of the TO header is a second distance which is larger than the first distance.

Preferably, a preset solder area is provided on the ceramic substrate, and the EML chip is cured on the preset solder area of the ceramic substrate.

Preferably, the heat insulation block is a quartz substrate, an upper surface of the quartz substrate being plated with a conductive layer, and a lower surface of the quartz substrate being fixed on the TO header.

Preferably, a reflecting mirror, a backlight detector MPD, and a filter capacitor are further provided on the ceramic substrate, and are fixed on the ceramic substrate.

Preferably, the high-speed EML coaxial transmitting module further comprises a TO cap, which is fixed with the TO header by seal welding, and at a light outlet of which a lens is provided.

In a second aspect, the present disclosure provides a manufacturing method for a high-speed EML coaxial transmitting module. The manufacturing method is used to manufacture the high-speed EML coaxial transmitting module as described in the first aspect. The manufacturing method comprises:
bonding the first surface of the TEC on the TO header, and bonding the EML chip on the ceramic substrate;
bonding the ceramic substrate on the second surface of the TEC;
bonding the thermistor on the ceramic substrate, wherein the lower surface of the thermistor is fixed on the ceramic substrate and close to the EML chip, the upper surface of the thermistor is electrically connected to the pad of the ceramic substrate, and the pad of the ceramic substrate is electrically connected with the thermistor pin on the TO header.

The present disclosure provides a high-speed EML coaxial transmitting module and a manufacturing method thereof. The high-speed EML coaxial transmitting module comprises a TO header, a TEC, a ceramic substrate, an EML chip, and a thermistor. A first surface of the TEC is arranged on the TO header. The ceramic substrate is arranged on a second surface of the TEC. The EML chip is arranged on the ceramic substrate. A lower surface of the thermistor is fixed on the ceramic substrate and close to the EML chip, and a upper surface of the thermistor is electrically connected to a pad of the ceramic substrate. The pad of the ceramic substrate is electrically connected to a thermistor pin on the TO header. In the present disclosure, the temperature of the upper and lower surfaces of the thermistor is enable to be as consistent with each other as possible under high and low temperature conditions, thereby ensuring the DWDM wavelength stability at high and low temperature.

Further, the high-speed EML coaxial transmitting module provided by the present disclosure is used in a DWDM operating temperature module, and the full temperature power consumption is controlled within 1.5W.

Furthermore, the coaxially packaged high-speed EML transmitting module provided by the present disclosure has advantages of low cost and easy mass production compared with the existing BOX packaged EML transmitting module.

### BRIEF DESCRIPTION OF THE DRAWINGS

In order to explain embodiments of the present disclosure or the technical solutions in the prior art more clearly, the drawings necessary for the description of the embodiments or the prior art will be briefly introduced hereinafter. Obviously, the drawings in the following description are only some embodiments of the present disclosure. For those of ordinary skill in the art, other drawings can be obtained based on these drawings without creative work.
FIG. 1 is an overall schematic diagram of a high-speed EML coaxial transmitting module provided by a first embodiment of the present disclosure;
FIG. 2 is a bottom view of pins of the high-speed EML coaxial transmitting module provided by the first embodiment of the present disclosure;
FIG. 3 is a schematic diagram of a TEC of the high-speed EML coaxial transmitting module provided by the first embodiment of the present disclosure, which is bonded on a TO header;
FIG. 4 is a top view of a TEC of the high-speed EML coaxial transmitting module provided by the first embodiment of the present disclosure, which is bonded on the TO header;
FIG. 5 is a structural diagram of a ceramic substrate of the high-speed EML coaxial transmitting module provided by the first embodiment of the present disclosure;
FIG. 6 is a schematic diagram of assembling an EML chip of the high-speed EML coaxial transmitting module of the first embodiment of the present disclosure on a ceramic substrate;
FIG. 7 is an assembly diagram of bonding internal components of the high-speed EML coaxial transmitting module provided by the first embodiment of the present disclosure;
FIG. 8 is a structural diagram of a heat insulation block of the high-speed EML coaxial transmitting module provided by the first embodiment of the present disclosure;
FIG. 9 is an assembly diagram of finishing bonding of the high-speed EML coaxial transmitting module of the first embodiment of the present disclosure;
FIG. 10 is a variation curve of wavelength of the high-speed EML coaxial transmitting module provided by the first embodiment of the present disclosure with housing temperature of the DWDM operating temperature module;
FIG. 11 is a schematic flowchart of a manufacturing method for a high-speed EML coaxial transmitting module provided by a second embodiment of the present disclosure.

### DETAILED DESCRIPTION

In order to make the objectives, technical solutions, and advantages of the present disclosure clearer, the present disclosure is further described in detail hereinafter with reference to the accompanying drawings and embodiments. It should be understood that the specific embodiments described herein are only used to explain the present disclosure, but not to limit the present disclosure.

In the description of the present disclosure, the terms "inner", "outer", "longitudinal", "horizontal", "upper", "lower", "top", "bottom", etc. indicate the orientation or positional relationship based on the accompanying drawings, which are only shown for the convenience of describing the present disclosure and does not require that the present disclosure must be constructed and operated in a specific orientation. Therefore, it should not be understood as a limitation to the present disclosure.

In the embodiments of the present disclosure, the symbol "/" indicates two functionals at the same time. For example, "a second optical inlet/outlet port" indicates that the port can both allow light to enter or emit. For the symbol "A and/or B", it indicates that the combination of the front and rear objects connected by the symbol comprises three situations, that is "A", "B", and "A and B", such as "backscattered light and/or reflected light" means that it can express any of the three meanings as follows: "backscattered light" alone, "reflected light" alone, and "backscattered light and reflected light".

In addition, the technical features involved in various embodiments of the present disclosure described below can be combined with each other as long as they do not conflict with each other.

### Embodiment 1

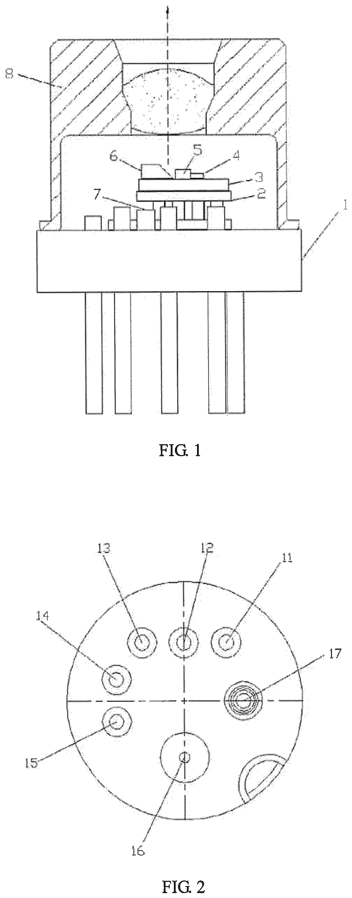

A first embodiment of the present disclosure provides a high-speed EML coaxial transmitting module, which is applied to a DWDM operating temperature module. As shown in FIG. 1, the high-speed EML coaxial transmitting module comprises a TO header 1, a TEC 2, a ceramic substrate 3, an EML chip 4, and a thermistor 5. Optionally, the high-speed EML coaxial transmitting module further comprises a reflecting mirror 6. Whether the reflecting mirror 6 needs to be provided is determined based on whether the selected EML is vertically placed or horizontally placed, namely whether the method for placing the selected EML is a vertical placement of the EML or a horizontal placement of the EML. In the embodiment of the present disclosure, the structure will be described in the case that the reflecting mirror 6 is provided and the EML is horizontally placed. Correspondingly, those skilled in the art can know that if the structure of the EML is placed vertically, the reflecting mirror 6 is not necessary; the combinations of the above-mentioned several options are all within the protection scope of the present disclosure.

In the first embodiment of the present disclosure, the first surface of the TEC 2 is arranged on the TO header 1, and the ceramic substrate 3 is arranged on the second surface of the TEC 2, wherein the first surface is a hot side of TEC 2, and the second surface is a cold side of TEC 2. The EML chip 4 is arranged on the ceramic substrate 3, and the reflecting mirror 6 is arranged on the ceramic substrate 3 for totally reflecting light emitted from the EML chip 4, wherein the direction in which the light is emitted is a direction of a dotted arrow. A lower surface of the thermistor 5 is fixed on the ceramic substrate 3 and close to the EML chip 4. An upper surface of the thermistor 5 is electrically connected to a pad 312 on the ceramic substrate 3, and the pad 312 of the ceramic substrate 3 is electrically connected to a thermistor pin 13 on the TO header 1. The lower surface of the thermistor 5 is cured on the ceramic substrate 3 through a conductive adhesive process, and the reflecting mirror 6 may be cured on the ceramic substrate 3 through a conductive adhesive processor a suitable insulating adhesive process, which is not limited here. The ceramic substrate 3 is cured on the second surface of the TEC 2 through a conductive adhesive process. The temperature near the lower surface of the thermistor 5 is the same, and the upper surface of the thermistor 5 is electrically connected to the pad of the ceramic substrate 3, the purpose of which is to enable the temperature of the upper surface of the thermistor 5 is also close to the temperature of the ceramic substrate, so that the temperature of the upper surface of the thermistor 5 is as consistent with the temperature of the lower surface of the thermistor 5 as possible. Further, the high-speed EML coaxial transmitting module further comprises a heat insulation block 7. A lower surface of the heat insulation block 7 is fixed on the TO header 1, and a conductive layer 71 is provided on an upper surface of the heat insulation block 7. One end of the conductive layer 71 on the upper surface of the heat insulation block 7 is electrically connected to the pad 312, and the other end of the conductive layer 71 on the upper surface of the heat insulation block 7 is electrically connected to the thermistor pin 13 on the TO header 1, which, on one hand, plays a role of thermal isolation, and on the other hand increases the thermal conduction distance, thereby greatly reducing external heat conducted to the upper surface of the thermistor 5, so that the temperature of the upper and lower surfaces of the thermistor 5 are as consistent with each other as possible.

As shown in FIG. 2, the TO header 1 is also provided with a backlight detector MPD positive pin 11, a laser positive pin 12, a thermistor pin 13, a thermoelectric refrigeration positive pin 14, a thermoelectric refrigeration negative pin 15, a radio frequency pin 16, and a ground pin 17; wherein the TEC 2 has a TEC anelectrode (or referred to as "positive electrode") electrically connected to the TEC positive pin 14and a TEC cathode (or referred to as "negative electrode") electrically connected to the TEC negative pin 15.

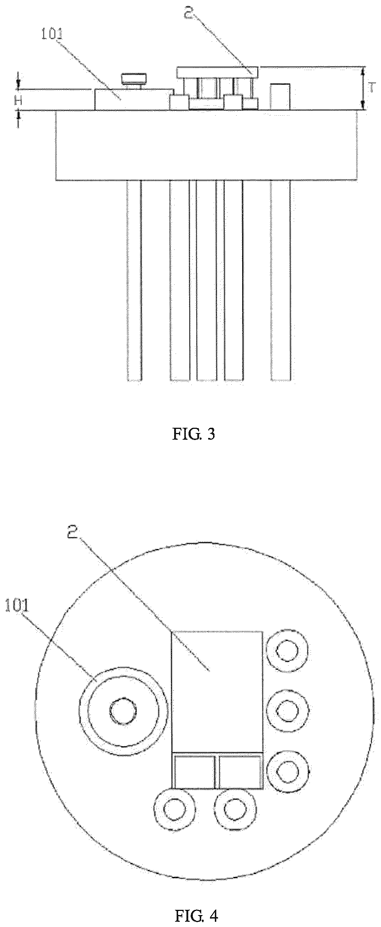

As shown in FIG. 3 and FIG. 4, a boss 101 is provided at a concentric position of the radio frequency pin 16 on the TO header 1. The boss 101 has a circular ring structure. The radio frequency pin 16 serves as an inner conductor, and the boss 101 serves as an outer conductor. The radio frequency pin 16 and the boss 101 form a segment of radio frequency coaxial transmitting line, the impedance of which is a predetermined value. The outer surface of the boss 101 is electrically connected to the TO header 1, and between the inner surface of the boss 101 and the radio frequency pin 16, glass solder is filled for sintering and fixing (the glass solder is an insulating material), thus, the design structure guarantees an impedance of the coaxial transmitting line is 50 ohms, and the radio frequency pin 16 is used for high-speed signal input. A distance between the upper surface of the boss 101 and the upper surface of the TO header 1 is a first distance H. The TEC 2 is a miniaturized TEC that can be placed inside a TO-CAN. The TEC 2 is cured on the TO header 1 through a conductive adhesive or through a eutectic soldering process. The eutectic soldering process used here can be AuSn (280°C), SnBi (139°C) or SnAgCu (217°C) eutectic soldering methods, but not limited to them here. The first surface of the TEC 2 is a soldering surface. A distance between the upper surface of the TEC 2 and the surface of the TO header 1 is a second distance T, and the first distance H is smaller than the second distance T. For example, when the second distance T is designed to be 0.8mm, the first distance H can be designed to be 0.4mm, in order to reduce the influence of the heat radiation of the boss 101 on the refrigeration power consumption of the TEC 2 under high temperature conditions, and to reduce the power consumption of the DWDM operating temperature module at high temperature.

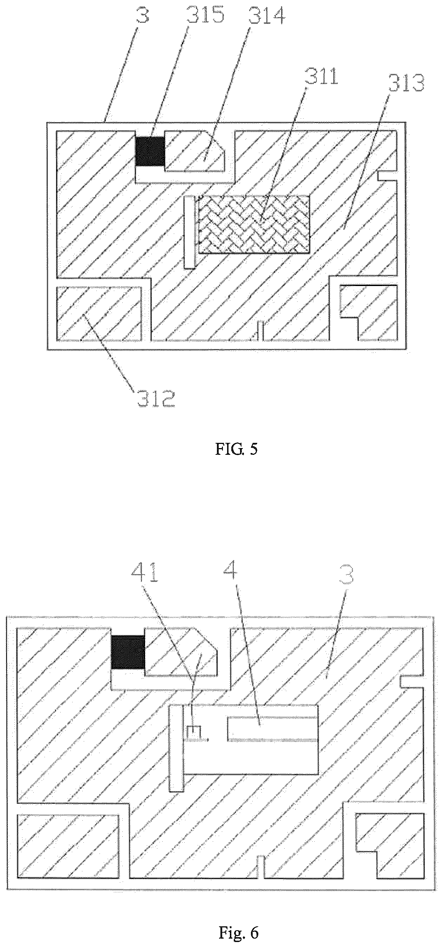

As shown in FIG. 5, the ceramic substrate 3 is preferably made of a material of aluminum nitride. The ceramic substrate 3 is provided with a preset solder area 311, a pad 312 and a ground layer 313. The preset solder area 311 is provided on the center of the ceramic substrate for fixing the EML chip 4. The pad 312 is arranged on a corner of the upper surface of the ceramic substrate for electrical connection with the thermistor 5. The ground layer 313 is a metal-plated layer for the ceramic substrate 3 to be grounded.

As shown in FIG. 6, the EML chip 4 may be cured on the preset gold-tin solder area 311 of the ceramic substrate 3 by using an AuSn (280°C) eutectic soldering process, then an automatic wedge soldering process is used to complete the soldering of the wedge soldering wire 41 on the EML chip 4, and the EML chip 4 is positioned at a designated aligning position on the TO header 1. The wavelength of the EML chip 4 at a specific operating temperature meets the DWDM wavelength requirements specified by the International Telecommunications Union Telecommunications Standardization Sector ITU-T. For example, when the EML chip 4 works at 45°C, the wavelength of the EML chip 4 is controlled to be 1546.12nm for the DWDM wavelength.

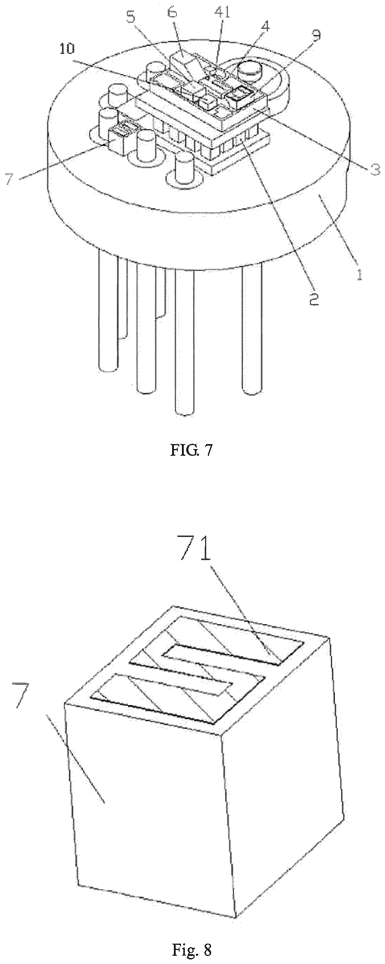

As shown in FIG. 7, in an optional solution, the ceramic substrate 3 is further provided with a backlight detector Monitor Photodiode (MPD) 9 and a filter capacitor 10. The MPD 9 and the filter capacitor 10 are fixed on the ceramic substrate by a conductive adhesive process; the TO header 1 is provided with a heat insulation block 7, which is positioned near the thermistor pin 13 on the TO header 1 through a conductive adhesive process, in order to facilitate electrical connection between the heat insulation block 7 and the thermistor pin 13.

The electrical connection between the pad 312 of the ceramic substrate 3 and the thermistor pin 13 on the TO header 1 is to prevent external heat from being easily conducted to the upper surface of the thermistor 5 and to maintain the temperature of the upper and lower surfaces of the thermistor as consistent with each other as possible. As shown in Figure 8, gold is plated on the heat insulation block 7 as a conductive layer 71, and the metal-plated conductive layer 71 of the heat insulation block 7 designed as an S-shaped. When the upper surface area of the heat insulation block 7 is constant, a trace distance of the S-shaped conductive layer is longer, resulting in a longer distance of heat conduction and an easier processing for the heat insulation block 7. A starting end of the S-shaped metal-plated conductive layer 71 is electrically connected to the pad 312 of the ceramic substrate 3 through gold bonding, and an ending end of the S-shaped gold-plated conductive layer 71 is electrically connected to the thermistor pin 13 through gold bonding too. The heat insulation block 7 is preferably made of quartz substrate characterized by low thermal conductivity, further thermally isolating the thermistor 5 from the outside, such that the above factors make it difficult for external heat to be conducted to the thermistor 5, thereby ensuring that the temperature of the upper and lower surfaces of the thermistor 5 are as consistent with each other as possible. Further, the upper surface of the thermistor 5 is electrically connected to the pad 312 of the ceramic substrate 3 via at least two gold bonding wires, so that the temperature of the upper and lower surfaces of the thermistor 5 are as consistent with each other as possible. The number of gold bonding wires can be two, three, four, or five, and it is not limited as long as the temperature of the upper and lower surfaces of the thermistor 5 can be as consistent with other as possible. All changes regarding the number of gold bonding wires made by those skilled in the art without paying any creative works will fall within the protection scope of the present disclosure.

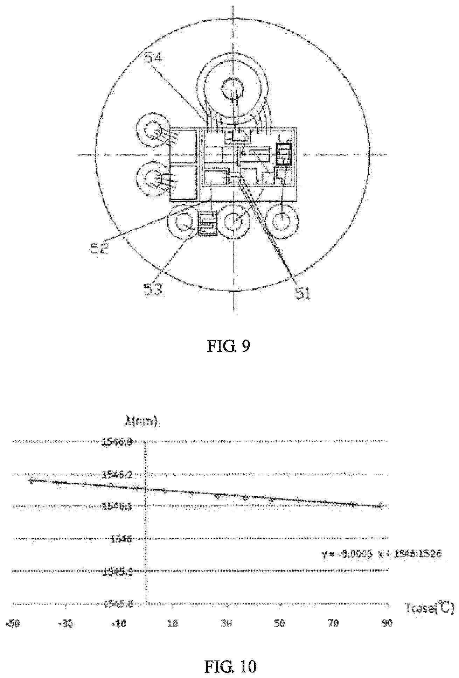

As shown in FIG. 9, a gold wire bonding process is used to complete the electrical connection between the internal components of the high-speed EML coaxial transmitting module: a cathode of the MPD 9 and the ground layer 313 of the ceramic substrate 3 are bonded to be electrically connected optionally by a gold bonding wire, an anelectrode of MPD 9 and a positive pin 11 of MPD are bonded to be electrically connected optionally by a gold bonding wire. A positive electrode of the EML chip 4 is electrically connected to the positive pin 12 of the EML chip by a filter capacitor 10 on the ceramic substrate 3 as a transition. The radio frequency pin 16 is bonded optionally by two gold bonding wires to be electrically connected to the transition pad 314 of the ceramic substrate 3. The transition pad 314 is electrically connected to the ground layer 313 through a resistor 315, where the transition pad 314 is a general design in the technical field. The radio frequency pin 16 provides a high-speed signal input for the EML chip 4 through the transition pad 314. The boss 101 can optionally be electrically connected to the grounding layer 313 of the ceramic substrate 3 through eight gold bonding wires. The purpose of using eight gold bonding wires is to ground the metal-plated grounding layer 313 of the ceramic substrate 3, and at the same time, eight gold wires bonding can reduce parasitic inductance and ensure the RF performance of the product. The thermistor 5 and the pad 312 of the ceramic substrate 3 are electrically connected optionally by three gold bonding wires, so that the temperature of the upper surface of the thermistor 5 is also close to the temperature of the ceramic substrate 3, and the temperature of the upper surface of the thermistor 5 and the temperature of the lower surface are as consistent with each other as possible. One end of the S-shaped metal-plated conductive layer 71 of the heat insulation block 7 is electrically connected to the pad 312 of the ceramic substrate 3 through a gold bonding wire 52, and the other end is electrically connected to the thermistor pin 13 through a gold bonding wire 53. On one hand, the low thermal conductivity of the heat insulation block 7 plays a role of thermal isolation. On the other hand, two gold bonding wires 52, 53 are used to be connected by wires with the S-shaped gold-plated conductive layer 71 of the heat insulation block 7, which increases the heat conduction distance. The above two factors make it difficult for external heat to be conducted to the thermistor 5, thereby ensuring that the temperature of the upper and lower surfaces of the thermistor 5 are as consistent with each other as possible. The above number of the gold bonding wires can also be other number, and those skilled in the art could change the number of the gold bonding wires without any creative works, and these changes also fall within the protection scope of the present disclosure.

The high-speed EML coaxial transmitting module is suitable for TO packaging. As shown in FIG. 1, the high-speed EML coaxial transmitting module further comprises a TO cap 8. The TO cap 8 and the TO header 1 are fixed by seal welding, and alight outlet of the TO cap 8 is provided with a lens. The seal welding fixation is performed by aligning the center of the lens with a central axis of the TO header 1 to perform resistance welding, and the TO cap 8 and the TO header 1 are thus connected together to complete the TO-CAN package.

The high-speed EML coaxial transmitting module of the first embodiment of the present disclosure is packaged into a transmitting device through optical path coupling, and is used for 10G long-distance SFP+ modules. Regarding the DWDM wavelength of 1546.12nm specified by ITU-T, by verification, it is determined that, when the housing temperature of a SFP+ module is tested within a temperature range of -43 ∼ 87°C, the wavelength variation of the device is 1546.178nm to 1546.1nm, the wavelength variation rate with the housing temperature of the SFP+ module being 0.6pm/°C, and a variation curve is shown in Fig. 10. In the full temperature range, the wavelength offset satisfies the DWDM wavelength tolerance range, while the full temperature power consumption of the tested SFP+ module is controlled within 1.5W.

The first embodiment of the present disclosure provides a high-speed EML coaxial transmitting module, which comprises a TO header, a TEC, a ceramic substrate, an EML chip, and a thermistor; a first surface of the TEC is arranged on the TO header, the ceramic substrate is arranged on a second surface of the TEC, the EML chip is arranged on the ceramic substrate, a lower surface of the thermistor is fixed on the ceramic substrate and close to the EML chip, a upper surface of the thermistor is electrically connected to a pad of the ceramic substrate, and the pad of the ceramic substrate is electrically connected to a thermistor pin on the TO header. The present disclosure may enable the temperature of the upper and lower surfaces of the thermistor as consistent with each other as possible under high and low temperature conditions, thereby ensuring the stability of the DWDM wavelength at high and low temperature.

Further, the high-speed EML coaxial transmitting module provided by the present disclosure is used for a DWDM operating temperature module, and the power consumption under full temperature is controlled within 1.5W.

Furthermore, the coaxially packaged high-speed EML transmitting module provided by the present disclosure has the advantages of low cost and easy for mass production compared to the existing BOX packaged EML transmitting module.

### Embodiment 2

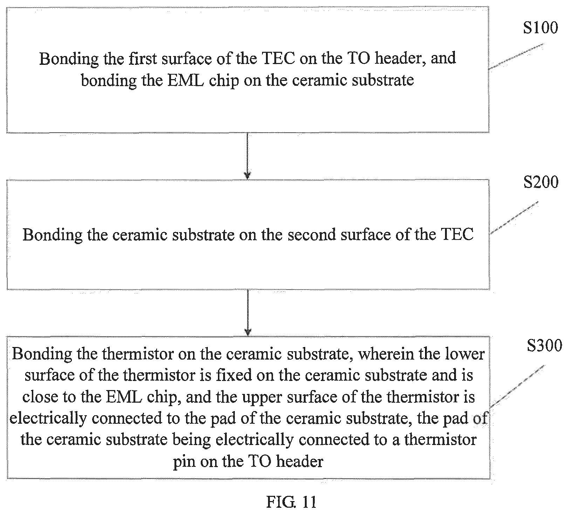

A second embodiment of the present disclosure provides a manufacturing method for a high-speed EML coaxial transmitting module. The high-speed EML coaxial transmitting module applies to a DWDM operating temperature module, and the manufacturing method is used to manufacture any one of the high-speed EML coaxial transmitting modules of the first embodiment of the present disclosure. Specific steps for the manufacturing method are shown in FIG. 11.

Step S100: bonding the first surface of the TEC on the TO header, and bonding the EML chip on the ceramic substrate.

The TEC 2 is bonded and cured on the TO header 1 through a SnAgCu (217°C) eutectic soldering process, and the first surface of the TEC 2 is a soldering surface. The EML chip 4 is bonded and cured on the prefabricated gold-tin solder area 311 of the ceramic substrate 3 by using the AuSn (280°C) eutectic soldering process, and then a wedge welding trace 41 on the EML chip 4 is completed by the automatic wedge welding process.

Step S200: bonding the ceramic substrate on the second surface of the TEC.

The ceramic substrate 3 attached with the EML chip 4 is bonded on a cold surface of the TEC 2 through a conductive adhesive process, and the EML chip 4 is positioned at a predetermined position on the TO header 1, and then the TO header is placed in an oven at 140°C to be baked for 40 minutes.

Step S300: bonding the thermistor on the ceramic substrate, wherein the lower surface of the thermistor is fixed on the ceramic substrate and is close to the EML chip, and the upper surface of the thermistor is electrically connected to the pad of the ceramic substrate, the pad of the ceramic substrate being electrically connected to a thermistor pin on the TO header.

The thermistor 5, the reflecting mirror 6, the backlight detector MPD 9, and the filter capacitor 10 are sequentially bonded on the ceramic substrate 3 through the conductive adhesive process, wherein the reflecting mirror is used to totally reflect the outgoing light of the EML chip 4, and the heat insulation block 7 is bonded on the TO header 1 near the thermistor pin 13 through the conductive adhesive process, and then the TO is placed in an oven at 140°C and baked for 40 minutes.

A gold wire bonding process is used to complete the electrical connection between the internal components of the high-speed EML coaxial transmitting module: the cathode of the MPD 9 and the ground layer 313 of the ceramic substrate 3 are electrically connected optionally by a gold bonding wire, the positive electrode of the MPD 9 and the positive pin 11 of the MPD are electrically connected optionally by a gold bonding wire; the positive electrode of the EML chip 4 is electrically connected to the positive pin 12 of the EML chip through the filter capacitor 10, serving as a transition, on the ceramic substrate 3; the radio frequency pin 16 is electrically connected to the transition pad 314 of the ceramic substrate 3 optionally by two gold bonding wires, and the transition pad 314 is electrically connected to the ground layer 313 through a resistor 315, here the transition pad 314 is in the common design in technical field, and the radio frequency pin 16 provides high-speed signal input for the EML chip 4 through the transition pad 314. The boss 101 can be electrically connected to the grounding layer 313 of the ceramic substrate 3 optionally by eight gold bonding wires. The purpose of bonding by using eight gold wires is to ground the gold-plated grounding layer 313 of the ceramic substrate 3, and at the same time, bonding with eight gold wires can reduce parasitic inductance and ensure the RF performance of the product. The thermistor 5 and the pad 312 of the ceramic substrate 3 are optionally electrically connected by three gold bonding wires, so that the temperature of the upper surface of the thermistor 5 is also close to the temperature of the ceramic substrate 3, enabling the temperature of the upper and lower surfaces of the thermistor 5 are as consistent as possible. One end of the S-shaped gold-plated conductive layer 71 of the heat insulation block 7 is electrically connected to the pad 312 of the ceramic substrate 3 through a gold wire bonding 52, and the other end is electrically connected to the thermistor pin 13 through a gold wire bonding 53. On one hand, the low thermal conductivity of the heat insulation block 7 plays a role of thermal isolation, and on the other hand, the trace connection by bonding two gold bonding wires 52, 53 to the S-shaped gold-plated conductive layer 71 of the heat insulation block 7 increases the heat conduction distance. The above two factors make it difficult for external heat to be conducted to the thermistor 5, thereby ensuring that the temperature of the upper and lower surfaces of the thermistor 5 are as consistent as possible. Among them, the above-mentioned number of the gold bonding wires can also be other numbers, and the number of gold welding wires made by those skilled in the art without creative efforts fall within the protection scope of the present disclosure.

The high-speed EML coaxial transmitting module is suitable for TO packaging. As shown in FIG. 1, it further comprises a TO cap 8, wherein the TO cap 8 and the TO header 1 are fixed by seal welding, and a lens is provided at a light output of the TO cap 8. At the place of the seal welding, resistance welding is performed by aligning the center of the lens with the central axis of the TO header 1, and the TO cap 8 and the TO header 1 are connected together to complete the TO-CAN package.

The above descriptions are only preferred embodiments of the present disclosure, and are not intended to limit the present disclosure. Any modification, equivalent replacement, and improvement made within the spirit and principle of the present disclosure shall be included within the scope of protection of the present disclosure.

## Claims

1. A high-speed EML coaxial transmitting module, **characterized in** comprising: a TO header (1), a TEC (2), a ceramic substrate (3), an EML chip (4), and a thermistor (5);
a first surface of the TEC (2) being provided on the TO header (1),
the ceramic substrate (3) being provided on a second surface of the TEC (2), and the EML chip (4) being provided on the ceramic substrate (3),
a lower surface of the thermistor (5) being fixed on the ceramic substrate (3) and close to the EML chip (4), and an upper surface of the thermistor (5) being electrically connected to a pad (312) of the ceramic substrate (3), and
the pad (312) of the ceramic substrate (3) being electrically connected to a thermistor pin (13) on the TO header (1).

2. The high-speed EML coaxial transmitting module of claim 1, **characterized in** further comprising a heat insulation block (7), a lower surface of which is fixed on the TO header (1);
the pad (312) of the ceramic substrate (3) being electrically connected to the thermistor pin (13) on the TO header (1), which specifically comprises:
one end of a conductive layer (71) on an upper surface of the heat insulation block (7) being electrically connected to the pad (312), and
the other end of the conductive layer (71) on the upper surface of the heat insulation block (7) is electrically connected to the thermistor pin (13) on the TO header (1).

3. The high-speed EML coaxial transmitting module of claim 2, **characterized in that** the upper surface of the thermistor (5) being electrically connected to the pad (312) of the ceramic substrate (3) specifically comprises:
the upper surface of the thermistor (5) being electrically connected to the pad (312) of the ceramic substrate (3) via at least two gold bonding wires.

4. The high-speed EML coaxial transmitting module of claim 1, **characterized in that** a boss (101) is provided on a concentric position of a radio frequency pin (16) of the TO header (1) and is a ring structure, and
the radio frequency pin (16) serves as an inner conductor, the boss (101) serves as an outer conductor, and both the radio frequency pin (16) and the boss (101) form a section of radio frequency coaxial transmitting line, the impedance of which is a predetermined value.

5. The high-speed EML coaxial transmitting module of claim 4, **characterized in that** a distance between an upper surface of the boss (101) and the upper surface of the TO header (1) is a first distance, and a distance between the upper surface of the TEC (2) and the upper surface of the TO header (1) is a second distance, wherein the first distance is smaller than the second distance.

6. The high-speed EML coaxial transmitting module of claim 1, **characterized in that** a preset solder area (311) is provided on the ceramic substrate (3), and the EML chip (4) is cured on the preset solder area (311) of the ceramic substrate (3).

7. The high-speed EML coaxial transmitting module of claim 2, **characterized in that** the heat insulation block (7) is a quartz substrate, and
the conductive layer (71) is plated on an upper surface of the quartz substrate, and a lower surface of the quartz substrate is fixed on the TO header (1).

8. The high-speed EML coaxial transmitting module of claim 1, **characterized in that** the ceramic substrate (3) is further provided with a reflecting mirror (6), a backlight detector MPD (9) and a filter capacitor (10), and the reflecting mirror (6), the MPD (9) and the filter capacitor (10) are fixed on the ceramic substrate (3).

9. The high-speed EML coaxial transmitting module of claim 1, **characterized in that** the high-speed EML coaxial transmitting module further comprises a TO cap (8), which is fixed with the TO header (1) by seal welding, and a lens is provided at a light outlet of the TO cap (8).

10. A manufacturing method for a high-speed EML coaxial transmitting module, **characterized in that** the manufacturing method is used to manufacture the high-speed EML coaxial transmitting module of any one of claims 1 to 9, and comprises:
bonding the first surface of the TEC on the TO header, and bonding the EML chip on the ceramic substrate;
bonding the ceramic substrate on the second surface of the TEC;
bonding the thermistor on the ceramic substrate, wherein the lower surface of the thermistor is fixed on the ceramic substrate and close to the EML chip, and the upper surface of the thermistor is electrically connected to the pad of the ceramic substrate, and the pad of the ceramic substrate is electrically connected to the thermistor pin on the TO header.
